# EUROPEAN PATENT SPECIFICATION

(11) **EP 0 496 583 B1**
(45) Date of publication and mention of the grant of the patent: **29.04.1998**
(21) Application number: 92300508.6
(22) Date of filing: 21.01.1992
(51) Int. Cl.: H03H 9/19, H03H 9/05

(54) **KT cut width-extensional mode quartz crystal resonator**
Quarzkristall-Resonator im Breitenausdehnungsmodus mit KT-Schnitt
Résonateur à cristal de quartz en mode d'extension en largeur à coupure KT

(30) Priority: 25.01.1991 JP 7854/91; 06.08.1991 JP 196864/91; 29.08.1991 JP 219025/91; 02.09.1991 JP 221725/91; 27.09.1991 JP 249840/91; 08.11.1991 JP 293424/91
(43) Date of publication of application: 29.07.1992
(73) Proprietor: SEIKO ELECTRONIC COMPONENTS LTD., Sendai-shi, Miyagi-ken 982 (JP)
(72) Inventor: Kawashima,Hirofumi,c/o Seiko Electr.Components Ltd, Sendai-shi, Miyagi (JP)
(74) Representative: Sturt, Clifford Mark

(56) References cited:
- EP-A- 0 277 272
- EP-A- 0 350 443
- GB-A- 2 020 898
- GB-A- 2 224 159
- US-A- 4 148 530
- NACHRICHTEN ELEKTRONIK vol. 34, no. 6, June 1980, HEIDELBERG DE pages 201 - 202 T.FRENSCH 'Schwingquarze mit zweimal gedrehter Schnittebene verbessern die Frequenzstabilit t von Ostillatoren'
- PATENT ABSTRACTS OF JAPAN vol. 6, no. 147 (E-123)(1025) 6 August 1982 & JP-A-57 068 920 ( MATSUSHITA ) 27 April 1982

## Description

The present invention relates to a width-extensional mode quartz crystal resonator having specific features of a KT cut angle, thickness-to-width ratio, configuration and excitation electrode structure and method of manufacture. Particularly, the invention relates to the width-extensional mode quartz crystal of the type most suitable for use in a reference signal source of pagers, IC cards, and vehicle telecommunication, in which a resonator is required having a compact size, high accuracy, shock resistance and low cost.

Conventionally, a thickness shear mode quartz crystal resonator is used in a frequency range around 4 MHz. The oscillating frequency of this type of resonator is determined substantially by its thickness. Particularly, there is preferably used an AT cut type of resonator which features good frequency temperature behaviour. This type of resonator is produced by mechanical machining. However, problems have been encountered with the conventional AT cut quartz crystal resonator when reducing its size since it is formed by mechanical working. For example, it is difficult to mount, causes an increase in series resistance R₁ and causes generation of spurious responses. Thus, miniturization of the resonator is limited. Further, this type of the resonator has various drawbacks when used as a very small size of oscillating source in various portable instruments such as poor shock resistance and limitation in cost reduction because of individual machining of the resonator element, Thus, there has been long desired a quartz crystal resonator which features an oscillating frequency over 4 MHz, very small size, reduced series resistance R₁, zero temperature coefficient capable of being formed by an etching process.

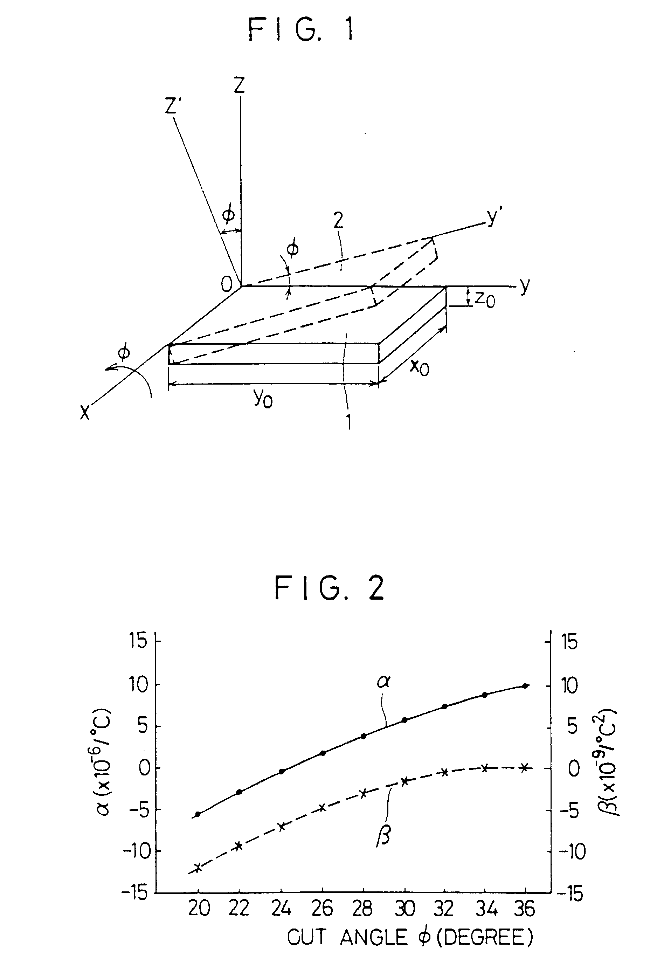

EP-A-0 350 443 provides a quartz crystal resonator having its first order thermal coefficient close to zero at the average utilisation temperature. This resonator is provided by cutting a quartz piece at an angle φ to the electric axis of a ZY cut substrate. The resonator taught by EP-A-0 350 443 has the angle φ as approximately 20° 24' and the ratio of the width to the length, w/1, of the quartz piece approximately equal to 0.64. The ratio w/1 is equivalent to the ratio x_{O}/y_{O} for the dimensions discussed in relation to Figure 1 of this specification.

An object of the present invention is to provide a new cut of the width-extensional mode quartz crystal resonator obviating the above disadvantages.

Another object of the present invention is to determine an optimum thickness-to-width ratio effective to improve frequency-temperature characteristics of the width-extensional mode quartz crystal resonator.

A further object of the present invention is to provide an excitation electrode structure effective to reduce series resistance R₁ of the resonator.

A still further object of the present invention is to provide the width-extensional mode quartz crystal resonator having a small shape effective to reduce dissipation of the oscillating energy of the resonator.

In its simplest form, the present invention achieves the above objects by providing a width-extensional mode quartz crystal resonator which comprises a quartz crystal piece cut along a z' plane which has been rotated about the x axis by an angle in the range 20° - 35°.

That is to say according to the present invention, a new cut angle is contemplated in the width-extensional mode quartz crystal resonator in order to achieve excellent frequency-temperature characteristics. Namely, in order to determine a cut angle of the width-extensional mode quartz crystal resonator which undergoes expanding and contracting oscillation in the width direction, there is defined a z plane which is perpendicular to the z axis of the quartz crystal lattice structure. Then, the z plane is rotated around the x axis in the counterclockwise direction by an angle φ in the range of 20°-35° to define a new plane. A quartz crystal plane is cut along this new plane to produce the width-extensional quartz crystal resonator which can achieve a desired frequency temperature behaviour within a set range of the cut angle φ.

Also the thickness-to-width ratio of the resonator can be suitably set to obtain a desired first order temperature coefficient.

Furthermore, the excitation electrode of the resonator is suitably arranged to facilitate oscillation of the width-extensional mode quartz crystal resonator which undergoes significant vibration in the widthwise direction, thereby reducing the series resistance.

According to the present invention there is provided a width-extensional mode quartz crystal resonator as defined in claim 1

Embodiments of the present invention will now be described with reference to the accompanying drawings, of which:
Fig. 1 shows a width-extensional mode quartz crystal resonator and its coordinate system according to a preferred embodiment of the present invention;
Fig. 2 is a graph showing the relationship between the cut angle φ, and the first and second order temperature coefficients α, β for the preferred embodiment;
Fig. 3 is a graph showing examples of the frequency temperature behaviour curves while different cut angles φ are set as a parameter;
Fig. 4 is a graph showing the relationship between the thickness-to-width ratio R_{zx} and the first order temperature coefficient while different cut angles φ are set as a parameter;
Fig. 5 is a graph showing another example of the frequency temperature behaviour;
Fig. 6 is a graph showing the relationship between the resonator width xₒ and the resonance frequency f in the fundamental vibration;
Figs. 7A, 7B and 7C are sectional views of different excitation electrode structures effective to induce fundamental vibration in the KT cut width-extensional mode quartz crystal resonator;
Fig. 8 is a perspective view of an excitation electrode structure effective to induce the third order overtone in the KT cut width-extensional mode quartz crystal resonator;
Fig. 9 is a sectional view of an excitation electrode structure effective to induce the fifth order overtone in the KT cut width-extensional mode quartz crystal resonator;
Fig. 10 is another sectional view of an excitation electrode structure effective to induce the seventh order overtone in the KT cut width-extensional mode quartz crystal resonator;
Fig. 11 shows a perspective view of a width-extensional mode quartz crystal resonator and its coordinate system according to the preferred embodiment;
Fig. 12 shows another perspective view of a different shape of a width-extensional mode quartz crystal resonator and its coordinate system;
Fig. 13 is a plan view showing a shape of and an excitation electrode configuration for a width-extensional mode quartz crystal resonator of the preferred embodiment; and
Fig. 14 is another plan view showing a shape of and an excitation electrode configuration for a width-extensional mode quartz crystal resonator.

Fig. 1 shows a preferred embodiment of a width-extensional mode quartz crystal resonator 1 and its coordinate system of the present invention. The coordinate system comprises an origin point 0, an electrical axis x, a mechanical axis y and an optical axis z to thereby constitute the system O-xyz. A resonator 1 has a width xₒ and a length yₒ, and is constructed to vibrate by expansion and contraction in the widthwise direction. The resonator 1 is cut from the Z plane which is perpendicular to the z axis. On the other hand, a practical and actual resonator 2 indicated by the dashed line is cut from another Z plane which is defined by rotating the original Z plane around the x axis in the counterclockwise direction by a cut angle φ in the range 20° - 35°. Hereinafter, this cut mode is referred to as "KT cut". The rotated coordinate system is indicated by O-x'y'z'. The temperature coefficients of the quartz elastic stiffness and the thermal expansion coefficients vary depending on the cut angle φ. A desired frequency temperature behaviour can be obtained by selecting suitably the cut angle. Hereinafter, the frequency temperature behaviour will be described in detail in terms of the cut angle φ.

Fig. 2 shows the relationship between the cut angle φ, and the first order temperature coefficient α and second order temperature coefficient β for the preferred embodiment when the width-extensional mode quartz crystal resonator has a thickness zₒ much smaller than the width xₒ, and a length yₒ much greater than the width xₒ. As the cut angle φ increases from zero degree, the first order temperature coefficient rises such that when α = 0 the cut angle φ = 24.6°. Thus, one can obtain a width-extensional mode quartz crystal resonator having a zero temperature coefficient approximately at room temperature. As the angle increases further, α increases accordingly. By such manner the first order temperature coefficient α significantly varies depending on the cut angle φ. Hence, the turning temperature point can be set in a desired range of temperature. On the other hand, the second order temperature coefficient β = -1.21 x 10⁻⁸/°C², at φ = 20°. As the angle φ increases, the absolute value of β decreases such that β = -0.925 x 10⁻¹⁰/°C² at φ = 35°. Since the absolute value of β is relatively small when α = 0, one can obtain a width-extensional mode quartz crystal resonator having excellent frequency temperature behaviour.

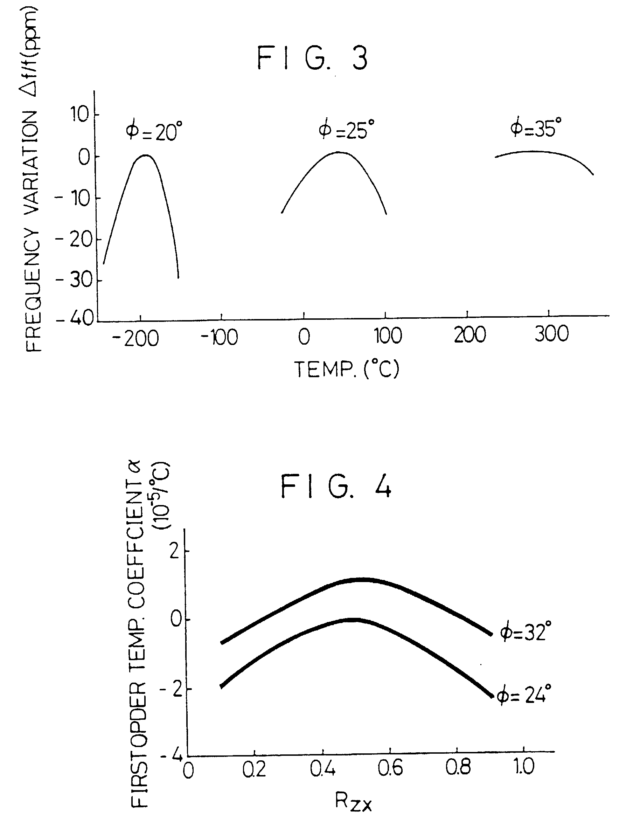

Fig. 3 shows examples of the frequency-temperature characteristics of the preferred embodiment of the width-extensional mode quartz crystal resonator when different cut angles φ are set as a parameter. Since α and β have negative values at φ = 20°, the turning temperature point Tp is set at a relatively low temperature. However, when α = 0 the cut angle is approximately φ = 25°. Hence Tp shifts to approximately room temperature. When, for example the cut angle φ = 35°, α takes a greater positive value and hence the turning temperature point Tp shifts to a relatively high temperature. In this manner, the turning temperature point Tp can be set in a desired range by suitably selecting the cut angle φ. For example, if the cut angle is set around φ = 20° then the excellent frequency temperature behaviour for the resonator is obtained in the low temperature range. On the other hand, the cut angle may be increased to about φ = 35° when the resonator is used in the high temperature range. In addition, as mentioned in conjunction with Fig. 2, β is set to -1.21 x 10⁻⁸/°C² at φ = 20°. The absolute value of β decreases further as φ increases. Accordingly, the width-extensional mode quartz crystal resonator can perform with better frequency temperature behaviour when Tp is set in the higher temperature range rather than in the lower temperature range.

Fig. 4 shows the relationship between the thickness-to-width ratio R_{zx} and the first order temperature coefficient while the cut angle φ is set at different values, e.g., when φ = 24° and 32°. The frequency temperature behaviour has been described above when the thickness-to-width ratio R_{zx} (thickness zₒ/width xₒ) is set very small. In contrast Fig. 4 indicates the change of the first order temperature coefficient α while the ratio R_{zx} is gradually increased. As the thickness-to-width ration R_{zx} increases, the effect of the thickness emerges thereby varying the value of α. In more detail, the behaviour of the width-extensional mode quartz crystal resonator is affected substantially by various subsidiary vibrations dependent on the thickness, including the followings:
(1) thickness shear vibration
(2) thickness extensional vibration
(3) lateral motion dependent on Poission's ratio in the thickness direction

Among these three vibration modes, the lateral motion normally affects the value of the first order temperature coefficient α independently of the thickness though the degree of the affect may vary. As shown in Fig. 4, as the thickness-to width ratio R_{zx} increases (that is to say the thickness zₒ increases while the width xₒ is fixed), the thickness shear vibration, which is dependent on the thickness, adds to the principal vibration of the width-extensional mode quartz crystal resonator to thereby further shift α to a greater value. In this case, the thickness extensional vibration does not substantially add to the principal vibration. However, coupling of the thickness shear vibration to the principal vibration may become weaker as the ratio R_{zx} further increases, whilst coupling of the thickness extensional vibration to the principal vibration becomes stronger, thereby shifting α to a more negative value. This shift manner can be understood from the experimental data which generated Fig. 4. Further, as the cut angle φ is increased from 24° to 32° while the thickness-to-width ratio R_{zx} is fixed, α is further shifted to a more positive value. When the value of the first order temperature coefficient (α) is equal to zero, R_{zx} = 0.25 and R_{zx} = 0.8 when φ = 32°. When the cut angle φ is reduced to φ = 24°, α = 0 is set around R_{zx} = 0.5, thereby realising the zero temperature coefficient in the width-extensional mode quartz crystal resonator.

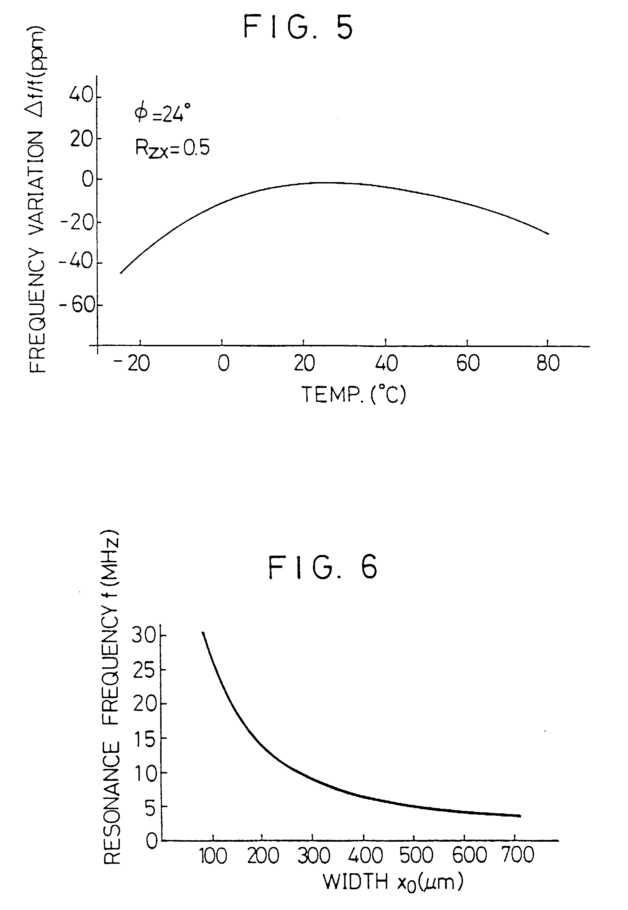

Fig. 5 shows another example of the frequency temperature behaviour of the preferred embodiment of the width-extensional mode quartz crystal resonator. In this example, the resonator is formed such that the cut angle φ = 24°, the thickness-to-width ratio R_{zx} = 0.5 and the resonance frequency f = 13.5 MHz. In this configuration, the resonator has the first order temperature coefficient α = -1.36 x 10⁻⁸/°C² which is quite close to zero, and the second order temperature coefficient β = -1.28 x 10⁻⁸/°C² which is smaller than that of the conventional DT cut resonator (β = -1.8 x 10⁻⁸/°C²), thereby realising excellent frequency-temperature characteristics.

Next, the description is given for the relationship between the dimension of width xₒ and the resonance frequency of the preferred embodiment of the width-extensional mode quartz crystal resonator. Fig. 6 is a graph showing the relationship between the width xₒ and the resonance frequency fin the fundamental vibration mode. Although the frequency constant (fₒ.xₒ) varies slightly, the frequency constant hovers around 270 kHz.cm in the fundamental vibration mode. Therefore, it is recognised that the width xₒ should be set less than xₒ = 675 µm in order to operate the resonator at a frequency of f = 4.0 MHz. Additionally, one can obtain higher multiple frequencies of the odd numbers, e.g. three, five, seven and so on, times the fundamental vibration frequency by utilising overtones. Further, in order to avoid coupling of the length extensional mode vibration to the fundamental or overtones which depends on the length yₒ, the length yₒ should be set far greater than the width xₒ. Moreover, the ratio xₒ/yₒ normally is set smaller than 0.1 in order to reduce the series resistance R₁. However, when the resonant frequency is set lower than 7 MH_{z}, since the width xₒ has a relatively large dimension, the aspect ratio xₒ/yₒ is set smaller than 0.2, in order to reduce the size of the resonator. Even in this case, the subsidiary length extensional mode vibration can be prevented from coupling to the main vibration.

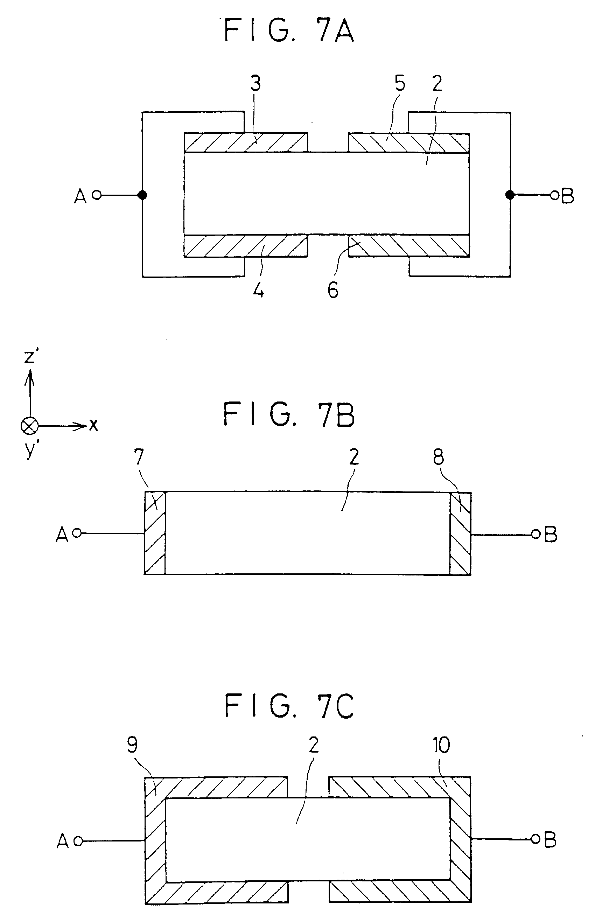

The description has been given hereinbefore for the relationship between the frequency-temperature characteristics and the resonant frequency. Hereinafter, the electrode construction for exciting the width-extensional mode quartz crystal resonator will be described. Figs. 7A, 7B and 7C show sectional views of different excitation electrode constructions of the KT cut width-extensional mode resonator.

Referring to Fig. 7A, one opposed pair of excitation electrodes 3,4 and another opposed pair of excitation electrodes 5, 6 are disposed on opposed faces of the width-extensional resonator 2, which are orthogonal to the z' axis. Further respective ones of the opposed pairs 3, 4 and 5, 6 are connected in the same polarity to provide a pair of electrode terminals A and B.

Referring to Fig. 7B, a pair of excitation electrodes 7, 8 are disposed respectively on opposite end faces of the width-extensional resonator 2. Each end face is formed by an etching process, thus called an etched face that is perpendicular to the x axis. In a manner similar to that in Fig. 7A, the pair of electrodes 7, 8 comprise the electrode terminals A, B.

Further, referring to Fig. 7C, a pair of excitation electrodes 9, 10 are disposed continuously on separate etched faces of the resonator 2, which are perpendicular to the z' axis and the x axis, thereby forming the pair of electrode terminals A, B in a similar manner.

In these constructions of Figs. 7A, 7B and 7C, an alternating voltage is applied across the pair of electrode terminals A and B to generate an electric field in the x direction. By such operation, the width-extensional mode quartz crystal resonator is excited efficiently to undergo a significant vibration in the widthwise direction of xₒ. Consequently, the series resistance R₁ can be considerably reduced in the width-extensional mode resonator. In addition, the dimensions of the excitation electrodes 3-10 are formed by taking account spurious vibrations and electrical field efficiency. Particularly, the dimension of the electrode along axis direction may be set to cover the entire length yₒ of the resonator piece so as to most effectively reduce the series resistance R₁.

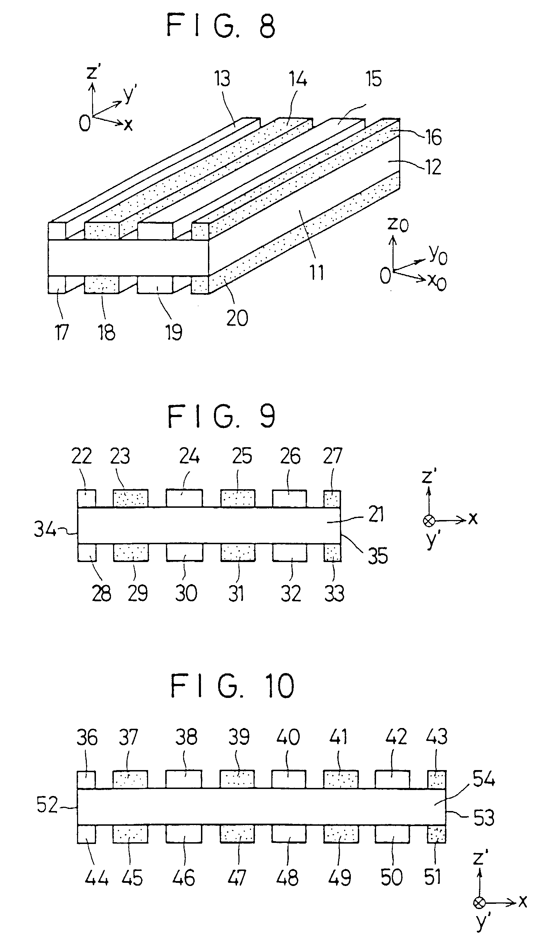

Fig. 8 shows a perspective view of an excitation electrode structure designed to induce a third order overtone in the KT cut width-extensional mode quartz crystal resonator. The resonator 11 has the length yₒ, width xₒ and thickness zₒ, dimensioned to satisfy the relation yₒ>>xₒ>zₒ. The resonator is formed by an etching process to leave each etched face 12. However, behind faces in the widthwise and lengthwise directions are hidden from the view. A plurality of excitation electrodes 13, 14, 15, 16, 17, 18, 19 and 20 are formed on opposed faces which are orthogonal to the etched face 12. One group of the excitation electrodes 13, 15, 17 and 19 are formed to receive the same polarity of a drive voltage, and another group of the exciting electrodes 14, 16, 18 and 20 are formed also to receive the same polarity of a drive voltage. The two groups of the electrodes are arranged to receive different polarities of the drive voltage, respectively. Accordingly, an alternating drive voltage is applied across the two groups of the exciting electrodes so as to induce the width-extensional mode vibration. In this embodiment, a piece of the width-extensional mode quartz crystal resonator 11 is cut from a Z plane which is defined by rotating the Z plane around the x axis by an angle φ in the range of 20°-35°. Consequently, the zero temperature coefficient is realised in the width-extensional mode resonator as described before.

Fig. 9 shows a sectional view showing an excitation electrode construction of the KT cut width-extensional mode quartz crystal resonator. Excitation electrodes 22-33 are arranged on opposed faces of the width-extensional mode quartz crystal resonator piece 21, which are perpendicular to etched faces 34, 35 of the resonator piece 21. The even number of excitation electrodes 22-32 and the odd number of excitation electrodes 23-33 are arranged to receive the opposite polarities of the drive voltage to thereby induce the fifth order overtone in the width-extensional mode quartz crystal resonator.

Fig. 10 is another sectional view showing a different excitation electrode construction of the KT cut width-extensional mode quartz crystal resonator. There are formed on opposed faces perpendicular to etched faces 52, 53 of the resonator piece 54 one group of excitation electrodes 36, 38, 40, 42, 44, 46, 48 and 50 of one polarity and another group of excitation electrodes 37, 39, 41, 43, 45, 47, 49 and 51 of another polarity. By such configuration, the seventh order overtone can be induced in the resonator piece.

As readily understood from Figs. 8, 9 and 10, a higher order overtone can be induced selectively according to the number of arranged excitation electrode segments. Generally in order to induce an n-th order overtone, there are arranged (n+ 1) number of excitation electrode segments on respective ones of opposed faces which are perpendicular to etched edge faces of the resonator piece such that each pair of the excitation electrodes opposed to one another in the direction zₒ are of the same polarity and an adjacent pair of the exciting electrodes in the widthwise direction are of the opposite polarities with one another. Consequently in the present invention, the width-extensional mode quartz crystal resonator features the resonant frequency over ten and several MHz, small series resistance R₁ and a high Q value.

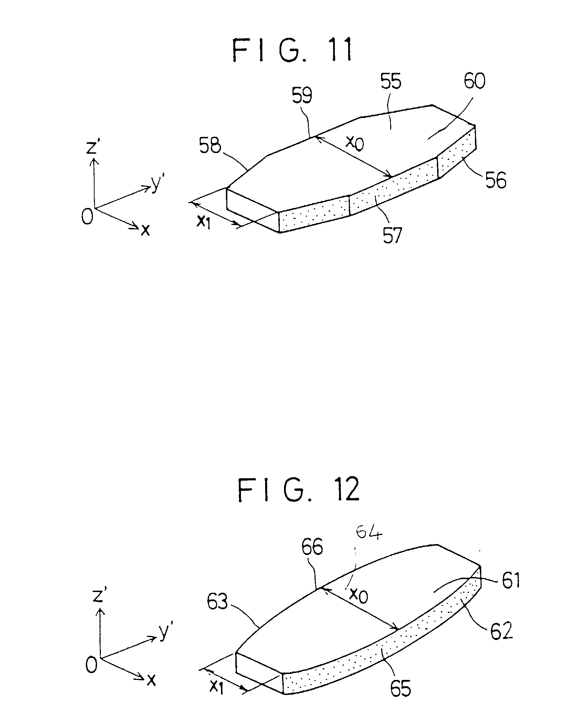

Fig. 11 is an overall view of a piece of the width-extensional mode quartz crystal resonator and its coordinate system O-x'y'z'. A resonator piece 55 has a pair of side faces 56, 58 in a bevel shape. Namely, a vibrating portion 60 has a central width xₒ and an end width x₁ so as to satisfy the relationship xₒ > x₁ by the bevel shaping. The resonator piece 55 is formed typically by a chemical etching process. Therefore, the side faces 56, 58 are called an etched face. Alternatively, the resonator piece may be shaped by mechanical processing. A central portion of each etched face is formed perpendicular to the electrical axis x of the quartz crystal lattice. Therefore, a pair of exciting electrodes 57 and 59 (the latter is hidden from view) are arranged at least in the vicinity of the intermediate portion of the respective etched faces. These excitation electrodes 57, 59 have leads to either of the major faces of the vibrating portion 60 for electrical connection to external terminals. Further as mentioned before, the y' axis and z' axis are respectively, a new mechanical axis and an optical axis defined after rotating the original Z plane around the x axis by an angle φ in the range of 20°-35°.

Fig. 12 shows an overall view of another shape of the width-extensional mode quartz crystal resonator piece and its coordinate system. The resonator piece 61 has a pair of side faces 62, 63 formed in a convex shape. Namely, a vibrating portion 64 has a central width xₒ and an end width x₁ designed to satisfy the relationship xₒ > x₁ to form the convex outer shape. Further, as mentioned in conjunction with Fig. 11, the side faces 62, 63 are called an etched face. These etched faces are provided with an excitation electrode 65 and another excitation electrode 66 hidden from view. These excitation electrodes 65, 66 have leads to either of the opposed major faces of the vibrating portion 64 for electrical connection to external terminals. In the Fig. 12 construction, as well as in the Fig. 11 construction, the excitation electrodes 57, 59, 65 and 66 are formed on the entire area of the side faces of the vibrating portion. However, these electrodes may be formed on only a part of the etched faces, or a part of the excitation electrodes may be extended over a part of the major face perpendicular to the thickness direction, i.e., the z' axis direction to thereby ensure sufficient electrical characteristics.

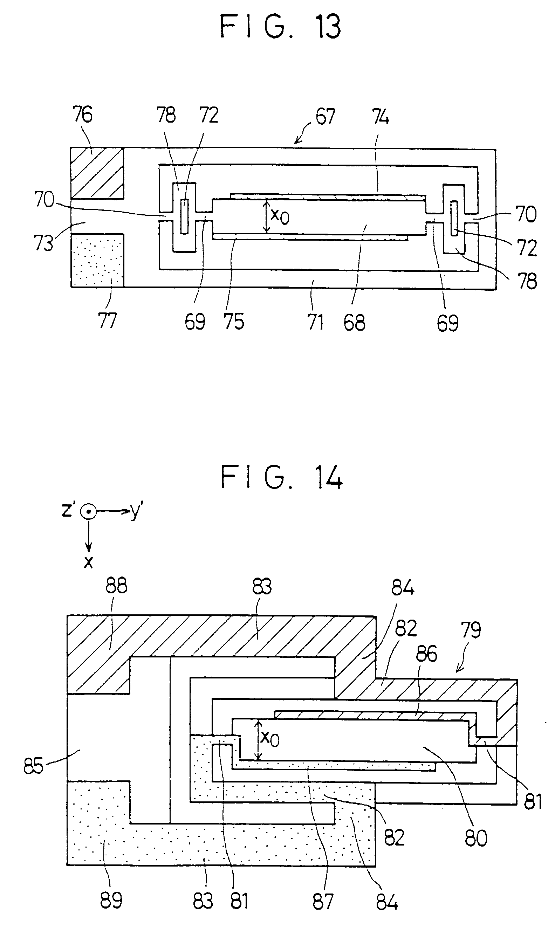

Fig. 13 is a plan view showing an overall configuration of the width-extensional mode quartz crystal resonator together with its excitation electrodes. The width-extensional mode quartz crystal resonator 67 comprises a vibrational portion 68, a pair of support portions 78, a frame portion 71 and a mount portion 73. These portions are formed integrally by an etching method. In detail, the vibrational portion 68 is connected to the pair of support portions 78 through corresponding bridge portions 69. The support portions 78 are disposed at lengthwise opposite ends of the vibrational portion 68. Further, each support portion 78 is formed with an opening 72. Another bridge portion 70 is disposd in opposite relation to the bridge portion 69 with respect to the opening 72. One of the support portions 78 is connected to the frame portion 71, and the other of the support portions 78 is connected to the mount portion 73. Further, the frame portion 71 is extended to the mount portion 73.

A pair of excitation electrodes 74, 75 are arranged in opposite polarity relation to each other on opposed faces of the vibrational portion 68, which are parallel to the lengthwise direction and perpendicular to the widthwise direction. One of the excitation electrodes 74 is electrically connected through the support portion 78 to a terminal electrode 76. In the same manner, the other excitation electrode 75 is led through the support portion to another terminal electrode 77. This way, a two-terminal electrode structure is formed on the mount portion 73. The respective support portions 78 are formed with separate electrodes of the opposite polarities. The exciting electrodes 74, 75 are formed after shaping the segments of the widthwise-extensional mode quartz crystal resonator. Though the excitation electrodes 74, 75 are formed on a part of the vibrational portion 68 in Fig. 13 embodiment, excitation electrodes may be formed on the entire area of the etched faces of the vibrational portion 68.

Fig. 14 is a plan view showing another configuration of the width-extensional mode quartz crystal resonator and its excitation electrode arrangement. The width-extensional mode quartz crystal resonator 79 comprises of a vibrational portion 80, a first frame 82, a second frame 83, a mount portion 85, and bridge portions 81, 84 which constitute a support. These segments are formed integrally by an etching method. In detail, the vibrational portion 80 is connected at its lengthwise opposite ends to the first frame 82 through the pair of bridge portions 81. Further, the first frame 82 is connected at its central portion to the second frame 83 through the other pair of bridge portions 84. The second frame 83 is extended to the mount portion 85. In this construction, the first frame 82 is formed to surround the vibrational portion 80. A pair of excitation electrodes 86, 87 are arranged in opposite polarity relation to each other on widthwise opposed faces of the vibrational portion 80, which are parallel to the lengthwise direction. One excitation electrode 86 leads to a terminal electrode 88 arranged on the mount portion 85, through the path of the bridge portion 81, the first frame 82, the bridge portion 84 and the second frame 83. In similar manner, the other excitation electrode 87 leads to another terminal electrode 89 formed on the mount portion 85, through the other path of the bridge portion 81, the first frame 82, the second bridge portion 84 and the other branch of the second frame 83. By such arrangement, a two-terminal electrode construction is formed on the mount portion 85, thereby reducing the size of the width-extensional mode quartz crystal resonator.

The aforegoing description has been given by way of example only and it will be appreciated that modifications can be made without departing from the scope of the present invention, as defined in the appended claims.

## Claims

1. A width-extensional mode quartz crystal resonator, comprising a quartz crystal piece (2,11,21,55,64,68,80) and excitation electrode means (3-10; 13-20; 22-33; 36-51; 57, 59; 65, 66, 74, 75; 86, 87) for inducing a width-extensional mode vibration in the quartz crystal piece, characterised in that the quartz crystal piece is formed from a quartz crystal which is cut along a plane defined by rotating a Z plane perpendicular to the z axis, representative of an optical axis of the quartz crystal, around an x axis representative of an electrical axis of the quartz crystal, by a given rotation angle set in the range of 20°-35°; wherein the quartz crystal piece has a thickness zₒ and a width xₒ such that a thickness-to-width ratio (R_{zx} = zₒ/xₒ) is in the range of 0.25-0. 80.

2. A width-extensional mode quartz crystal resonator according to claim 1, wherein the quartz crystal piece has a bevel shape or a convex shape.

3. A width extensional mode quartz crystal resonator according to claim 1 or claim 2, wherein the excitation electrode means (3-10; 13-20; 22-33; 36-51; 57, 59; 65, 66, 74, 75; 86, 87) is arranged on the quartz crystal piece at least along a face perpendicular to a z' axis which is defined by rotating the z axis around the x axis by the given rotation angle, or along an etched face (12; 34, 35; 52, 53, 56, 58; 62, 63) of the quartz crystal piece.

4. A width-extensional mode quartz resonator according to any one of claims 1 to 3, wherein the excitation electrode means comprises a plurality of excitation electrode segments.

5. A method of manufacturing a width extensional mode quartz crystal resonator as claimed in any one of claims 1 to 4, in which said resonator is formed from a quartz crystal piece having a thickness zₒ and a width xₒ such that a thickness-to-width ratio (R₂ₓ = zₒ/xₒ) is in the range of 0.25 -0.80, and includes mounting means (69-73,78; 81-85), said method comprising:
etching said quartz crystal piece (2, 11, 21, 55, 64, 68, 80) together with said mounting means from said quartz crystal.

## Patentansprüche

1. Breitenausdehnungsmodus-Quarzkristallresonator, umfassend ein Quarzkristallstück (2, 11, 21, 55, 64, 68, 80) und Anregungselektrodenmittel (3-10; 13-20; 22-33; 36-51; 57, 59; 65, 66, 74, 75; 86, 87) zum Anregen einer Breitenausdehnungsmodusschwingung in dem Quarzkristallstück,
**dadurch gekennzeichnet,** daß das Quarzkristallstück von einem Quarzkristall gebildet ist, der längs einer Ebene geschnitten ist, die durch Drehen einer Z-Ebene, welche orthogonal zu der eine optische Achse des Quarzkristalls darstellenden z-Achse ist, um eine eine elektrische Achse des Quarzkristalls darstellende x-Achse um einen gegebenen, im Bereich von 20°-35° festgelegten Drehwinkel definiert ist, wobei das Quarzkristallstück eine Dicke zₒ und eine Breite xₒ besitzt, derart, daß ein Dicke-Breite-Verhältnis (R_{zx} = zₒ/xₒ) im Bereich von 0,25-0,80 liegt.

2. Breitenausdehnungsmodus-Quarzkristallresonator nach Anspruch 1, bei dem das Quarzkristallstück eine abgeschrägte Form oder eine konvexe Form besitzt.

3. Breitenausdehnungsmodus-Quarzkristallresonator nach Anspruch 1 oder Anspruch 2, bei dem die Anregungselektrodenmittel (3-10; 13-20; 22-33; 36-51; 57, 59; 65, 66, 74, 75; 86, 87) an dem Quarzkristallstück zumindest entlang einer Fläche angeordnet sind, welche orthogonal zu einer z'-Achse liegt, die durch Drehen der z-Achse um die x-Achse um den gegebenen Drehwinkel definiert ist, oder entlang einer geätzten Fläche (12; 34, 35; 52, 53, 56, 58; 62, 63) des Quarzkristallstücks.

4. Breitenausdehnungsmodus-Quarzresonator nach einem der Ansprüche 1 bis 3, bei dem die Anregungselektrodenmittel eine Mehrzahl von Anregungselektrodensegmenten umfassen.

5. Verfahren zur Herstellung eines Breitenausdehnungsmodus-Quarzkristallresonators nach einem der Ansprüche 1 bis 4, bei dem der Resonator von einem Quarzkristallstück gebildet ist, das eine Dicke zₒ und eine Breite xₒ besitzt, derart, daß ein Dicke-Breite-Verhältnis (R_{zx} = zₒ/xₒ) im Bereich von 0,25-0,80 liegt, und Befestigungsmittel (69-73, 78; 81-85) umfaßt, wobei das Verfahren umfaßt: Ätzen des Quarzkristallstücks (2, 11, 21, 55, 64, 68, 80) zusammen mit den Befestigungsmitteln aus dem Quarzkristall.

## Revendications

1. Résonateur de cristal de quartz en mode d'extension en largeur, comportant une pièce (2, 11, 21, 55, 64, 68, 80) de cristal de quartz et des moyens (3-10 ; 13-20 ; 22-33 ; 36-51 ; 57, 59 ; 65, 66, 74, 75 ; 86, 87) formant électrode d'excitation destinés à induire une vibration de mode d'extension en largeur dans la pièce de cristal de quartz, caractérisé en ce que la pièce de cristal de quartz est formée à partir d'un cristal de quartz qui est découpé suivant un plan défini par la rotation d'un plan Z perpendiculaire à l'axe z, représentatif d'un axe optique du cristal de quartz, par rapport à un axe x représentatif d'un axe électrique du cristal de quartz, d'un angle de rotation donné réglé dans la gamme comprise entre 20 et 35° ; dans lequel la pièce de cristal de quartz a une épaisseur zₒ et une largeur xₒ de sorte qu'un rapport épaisseur à largeur (R_{ZX} = z_{O}/x_{O}) est compris entre 0,25 et 0,80.

2. Résonateur de cristal de quartz en mode d'extension en largeur suivant la revendication 1, dans lequel la pièce de cristal de quartz a une forme en biseau ou une forme convexe.

3. Résonateur de cristal de quartz en mode d'extension en largeur suivant la revendication 1 ou la revendication 2, dans lequel les moyens (3-10 ; 13-20 ; 22-33 ; 36-51 ; 57, 59 ; 65, 66, 74, 75 ; 86, 87) formant électrode d'excitation sont agencés sur la pièce de cristal de quartz au moins le long d'une face perpendiculaire à un axe z' qui est défini par la rotation de l'axe z par rapport à l'axe x de l'angle de rotation donné, ou le long d'une face gravée (12 ; 34, 35 ; 52, 53, 56, 58 ; 62, 63) de la pièce de cristal de quartz.

4. Résonateur de quartz à mode d'extension en largeur suivant l'une quelconque des revendications 1 à 3, dans lequel les moyens formant électrode d'excitation comportent une pluralité de segments d'électrode d'excitation.

5. Procédé de fabrication d'un résonateur de cristal de quartz en mode d'extension en largeur, tel que revendiqué dans l'une des revendications 1 à 4, dans lequel le résonateur est formé à partir d'une pièce de cristal de quartz ayant une épaisseur zₒ et une largeur xₒ de sorte que le rapport (R_{ZX} = z_{O}/x_{O}) épaisseur à largeur est compris entre 0,25 et 0,80, et comporte des moyens (69-73, 78 ; 81-85) de montage, le procédé comprenant l'étape qui consiste à :
graver la pièce (2, 11, 21, 55, 64, 68, 80) de cristal de quartz avec les moyens de montage à partir du cristal de quartz.
